Europäisches Patentamt

**European Patent Office**

**Office européen des brevets**

(11) Publication number: **0 076 392**

**A1**

# EUROPEAN PATENT APPLICATION

(21) Application number: **82108194.0**

(22) Date of filing: **06.09.82**

(51) Int. Cl.³: **G 01 L 9/10**
**G 01 L 9/00, G 01 D 5/20**
**G 01 R 17/10**

(30) Priority: **05.10.81 US 308752**

(43) Date of publication of application:
**13.04.83 Bulletin 83/15**

(84) Designated Contracting States:
**DE FR GB IT NL**

(71) Applicant: COMBUSTION ENGINEERING, INC.
1000 Prospect Hill Road
Windsor Connecticut 06095(US)

(72) Inventor: Dietrich, John Scott
53 Colony Drive
Winsted Connecticut 06098(US)

(74) Representative: Gross, Gernot K.
Kleiberweg 5
D-6200 Wiesbaden(DE)

(54) Bridge for reactive detector circuit.

(57) An improved transducer bridge circuit in a pressure gauge having reactive transducer elements such as inductance coils (18,18'). The electrical bridge includes first and second legs (28,30) each having a fixed resistor (22,22') in series with a coil (18,18'). The first and second legs (28,30) are connected in parallel whereby a resistor junction (24) and a coil junction (26) are formed at the extremities of the legs. A voltage oscillator (20) is connected to the resistor junction (24), and means (32) for maintaining a constant voltage are connected to the coil junction (26). A differential amplifier (36) is connected (A,B) to each leg between the fixed resistor (22,22') and the coil (18,18') such that the differential change in coil reluctances due to pressure variations, is amplified and manifested in a readout unit (34). This bridge is particularly advantageous when the oscillator (20) and electronic processing components (22,36,34) are to be located remotely, such as outside a nuclear containment building (10), relative to the sensing coils (18).

BRIDGE FOR REACTIVE DETECTOR CIRCUIT

BACKGROUND OF THE INVENTION

This invention relates to gauges or instruments for measuring the pressure of a fluid, and more particularly, to an electrical bridge for providing an accurate transducer signal to the readout of the gauge or instrument.

A wide variety of gauges or instruments is available for measuring the pressure or differential pressure of fluids in a pipe. Conventional equipment, however, has many deficiencies when used within the containment building of a nuclear power plant. The requirements for such use include high accuracy at temperatures over 400 F, pressures up to 3500 psi, and radiation to $2 \times 10^8$ Rads gamma.

As described in copending application Serial No. U. S. 273,871, filed January 2, 1981 for VARIABLE RELUCTANCE PRESSURE TRANSDUCER, a rugged, reliable and relatively inexpensive pressure transducer suitable for use in nuclear power plants, utilizes the principle of variable reluctance. In this design, a magnetically permeable diaphragm is subjected to the pressure differential to be measured, and the deflection or deformation of the diaphragm produces a differential reluctance in excited coils disposed adjacent to the diaphragm. The variable reluctance produces differential voltages which can be amplified and correlated with differential pressure.

A significant disadvantage of known transducers is that the transducer unit is typically located within the reactor containment building, while the output circuitry is desirably located up to 1000 feet from the variable reluctance coil. The voltage differentials generated in the transducer deteriorate considerably before reaching such remote readout circuit and, accordingly, the desired accuracy is not obtained. Thus, a need exists for improving upon conventional electronic bridges, such as the typical Wien bridge used in most variable reluctance or capacitance transducers, which are susceptible to the introduction of noise during the signal transmission over relatively long distances.

SUMMARY OF THE INVENTION

According to the present invention, an improved transducer bridge circuit is provided in a detector unit having reactive transducer elements for measuring fluid pressure. The inventive bridge includes first and second legs each having a fixed resistor in series with a reactive element, preferably an inductance coil. The first and second legs are connected in parallel whereby a resistor junction and a reactive element junction are formed at the extremeties of the legs. A voltage oscillator is connected to the resistor junction, and means for maintaining a constant voltage, such as ground is connected at the reactive element junction. The reactive elements are located within the transducer so as to produce a differentially varying reactance in response to a change in fluid pressure. A differential amplifier is connected between the fixed resistor and the reactive element on each leg such that the differential change in the reactances of the reactive elements is amplified and manifested in a readout unit.

Since the differential amplifier is connected to each leg in the same relative position between the respective resistances and reactive elements, any noise introduced anywhere along the legs will influence both legs substantially identically and be cancelled in the differential amplifier. Preferably the legs are maintained closely together in a shielded twisted triplet cable, both for ease of handling and to assure that any external influences on the legs will affect both legs similarly and, therefore, be cancelled in the differential amplifier.

In a further refinement of the invention, the exciting signal from the oscillator connected at the resistor junction of the parallel legs, is provided at a frequency of about between 100 to 2000 hertz, with a sinusoidal wave form having an amplitude of about 5 volts. These parameters were found to produce the best readout signals when the transducer coils must be located more than a few hundred feet from the oscillator and readout unit.

BRIEF DESCRIPTION OF THE DRAWINGS

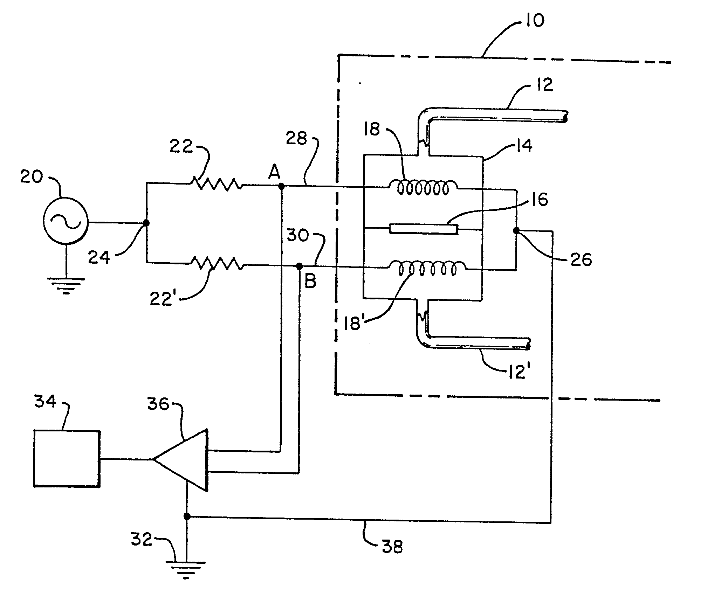

A more complete description of the preferred embodiment of the invention follows hereinbelow and in the accompanying Figure, which illustrates schematically the inventive bridge and its relationship with the transducer element and the readout circuit.

DESCRIPTION OF THE PREFERRED EMBODIMENT

Referring now to the Figure, the broken line 10 represents the concrete containment boundary of a nuclear power plant which separates the radioactive and potentially severe environment immediately surrounding the nuclear reactor vessel from the control room and display equipment (not shown). Schematic conduits 12, 12' represent taps from any pressurized fluid line in the nuclear power plant for which an absolute or differential pressure measurement must be made either for normal operator display or for input to protection and accident mitigation equipment. A transducer housing 14, as described in, for example, the aforementioned copending application No. 273,871, has mounted therein a magnetically permeable diaphragm 16 around which are disposed a pair of coils 18, 18'. An a.c. signal is passed from a voltage oscillator 20 through the coils 18, 18' such that when the diaphragm 16 deflects or deforms as a result of the differential pressure, the reluctance of the coils 18, 18' changes differentially.

The prior art includes a variety of transducers which operate on principles of variable reactance, such as the aforementioned variable reluctance transducers, or other types which use variable capacitance. The present invention is intended to cover any other transducer types that operate on the principle of a differential voltage produced by the differential influence of a mechanical transducer element upon two reactive elements.

According to the present invention, each reactive element or coil 18, 18' is connected in series to a resistor 22, 22', respectively, to form two substantially identical legs 28, 30 which are connected at the extremeties of the resistor end to form a resistor junction 24, and are connected at the extremeties of the coil end to form a reactive element junction 26. The two legs 28, 30 are, thus, connected in parallel whereby the voltage oscillator 20, which is connected to the resistor junction, imposes a common signal to both legs 28, 30, and the reactive element junction is maintained at a constant voltage such as ground 32.

It can be appreciated that at points A and B on the legs 28 and 30, respectively, the net voltage will be a result of the change in reluctances associated with the asymmetry produced by the deformation of the diaphragm 16. Since the total voltage drop across leg 28 equals the drop across leg 30, each leg 28, 30 will divide the total voltage drop differently, depending on the reluctances of the coils 18, 18'. The resulting difference in voltage at points A and B, which are between the resistor and reactive element in each leg, is utilized in the present invention to generate an accurate and substantially noise-free signal to the readout equipment 34.

A differential amplifier 36 is connected between points A and B such that the voltage divider effect across the legs 28, 30 is amplified sufficiently to operate the conventional readout unit 34. With the present invention, the differential signal between A and B is substantially noise-free and, therefore, is not degraded by the remote location of the oscillator and readout equipment 20, 34, relative to the transducer housing 14 and reactive elements 18, 18'.

In many nuclear-related uses, the distance between the coils 18, 18' and the control panel or readout unit 34 is over 1000 feet. It is inevitable that a variety of spurious signals will influence any electrical cables running through the containment building over such great distance, and this has posed a problem with prior art electronics associated with the gauges. With the present invention, the intermediate portion of each leg between the resistor element 22, 22' and the reactive elements 18, 18', is substantially the same length, and, in particular, the distance or electrical length from point A to the associated reactive element 18, and the distance or electrical length from point B to the associated reactive element 18' is identical. Thus, since the differential amplifier 36 operates on only the difference in voltages at A and B resulting from the differential reactances of 18, 18', any signals that are common to both legs from the transducer housing 14 to the points A and B are simply cancelled out by the amplifier 36.

In the preferred embodiment, legs 28, 30 and the common ground line 38 are all contained within a shielded twisted triplet cable running from the transducer housing 14 to the differential amplifier 36. The invention is particularly advantageous over conventional gauges, in plants where the distance from the transducer housing 14 to the containment wall 10 (or to points A and B which are typically in the control room) is more than about 250 feet.

Although the present invention provides significant improvements in the ability to obtain accurate differential voltage signals of reactive elements over a considerable distance, the invention is most efficiently used when the oscillating source 20 produces a signal within the frequency range of about 100 to 2000 hertz, with a sinusoidal wave having an amplitude of about 5 volts. Higher frequencies will be shunted by the increased capacitance of the cable due to insulation degradation under radiation and high temperature. Lower frequencies result in poor inductance measurements. The relatively low frequencies are more suitable for transmission over long cables, and the sinusoidal form of the wave does not

- 6 -

0076392

deteriorate as readily as, for example, a square wave.

As compared with typical prior art bridge circuits, the present invention requires more power from the oscillator 20 and associated electronics such as differential amplifier 36, but the improvement in output signal accuracy is a small price to pay, particularly in central power generating stations such as nuclear power plants.

The invention has been described in connection with a variable reluctance pressure transducer for use in a nuclear power plant. To those skilled in this art, it will be apparent that the invention may be used in other embodiments where the differential signals from reactive elements are used to provide an indication of fluid pressure.

CLAIMS

1. In a fluid pressure detector having reactive transducer elements and means adapted to connect to a readout unit, an improved transducer bridge circuit comprising:

a first leg having a fixed resistor in series with a reactive element;

a second leg having a fixed resistor and reactive element in the same series order as said first leg, said first and second legs connected in parallel whereby a resistor junction and a reactive element junction are formed at the extremities of the legs;

a voltage oscillator connected to the resistor junction;

means for maintaining a constant voltage at the reactive element junction;

means for differentially varying the reactance of the reactive elements in response to a change in the fluid pressure to be detected; and

a differential amplifier connected between the fixed resistor and the reactive element on each leg, the amplifier being adapted to input to the readout circuit, whereby a differential change in the reactances of said reactive elements is manifested in the readout unit, and any noise common to both legs is not amplified.

2. The improved transducer bridge of Claim 1, wherein the reactance elements are inductance coils.

3. The improved transducer bridge of Claim 2, wherein the oscillator frequency is in the range of about 100 to 2000 hz.

4. The improved transducer bridge of Claim 3, wherein the waveform generated by the oscillator is sinusoidal with an amplitude of about 5 volts.

5. The improved transducer bridge of Claims 1 or 4, wherein the respective portions of each leg between the reactance elements and the differential amplifier connections have substantially the same electrical length and are electrically insulated from each other.

6. The improved transducer bridge of Claim 5 wherein the distance between the reactive element and the amplifier connection on each leg is at least about 250 feet.

7. The improved transducer bridge of Claim 6, wherein the portion of each leg between the connection of the amplifier, and the reactive elements, is contained in a shielded, twisted cable.

8. The improved transducer bridge of Claim 1 wherein each of said legs is of substantially the same electrical length and is electrically insulated from the other.

9. A transducer unit for the detection of a fluid pressure in a nuclear power plant having a containment building comprising:

magnetically permeable means for deforming in response to changes in the fluid pressure;

a pair of inductance coils disposed about and magnetically coupled to said permeable means;

a fixed resistor in series with each of the coils, whereby two legs are formed, each having a resistor and coil in series;

a resistor junction joining the ends of the legs closest to the resistors and a coil junction joining the ends of the legs closest to the coils, whereby the two legs are joined electrically parallelly;

means for generating an oscillating electrical signal at the resistor junction;

means for maintaining a constant voltage at the coil junction; and

a differential amplifier connected between the resistor and coil on each leg, and having means thereon for delivering the amplified differential signal to an output circuit.

10. The transducer unit of Claim 9 wherein the magnetically permeable means and the coils are within the containment building, and the resistors, means for generating an oscillating signal, and differential amplifier connection to the legs are all outside the containment building.

**0076392**

11. The transducer unit of Claim 10 wherein the respective portions of each leg between the coil and the amplifier connections have the same electrical length and are electrically insulated from each other.

European Patent
Office

EUROPEAN SEARCH REPORT

## DOCUMENTS CONSIDERED TO BE RELEVANT

| Category | Citation of document with indication, where appropriate, of relevant passages | Relevant to claim |
|---|---|---|
| X | CH - A - 317 936 (DAIMLER-BENZ AG)<br>* claims 1, 2 ; fig. 4 *<br>-- | 1,2 |
| X | WO - A1 - 80/01951 (A. ROUSSEAU et al.)<br>* claims; fig. 1, 2, 5 *<br>---- | 1,2 |

**CLASSIFICATION OF THE APPLICATION (Int. Cl. ³)**

G 01 L   9/10

G 01 L   9/00

G 01 D   5/20

G 01 R   17/10

**TECHNICAL FIELDS SEARCHED (Int.Cl. ³)**

G 01 D   5/20

G 01 L   9/00

G 01 R   17/10

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| Berlin | 23-12-1982 | KÖHN |

EPO Form 1503.1   06.78